# EUROPEAN PATENT APPLICATION

(11) **EP 1 276 156 A1**
(43) Date of publication of application: **15.01.2003**
(21) Application number: 01810705.2
(22) Date of filing: 13.07.2001
(51) Int. Cl.: H01L 29/739

(54) **High power bipolar transistor**

(71) Applicant: ABB RESEARCH LTD., 8050 Zürich (CH)
(72) Inventor: Bauer, Friedhelm, 6714 Semione (CH)
(74) Representative: ABB Patent Attorneys

(57) **Abstract**

The central base region of the inventive high power bipolar transistor with an insulated control gate has a compensation structure for depleting charge carriers when a blocking voltage is applied. The compensation structure comprises columns of the first conduction type (12) and mutually spaced apart columns of the second conduction type (11). These colums are moderately doped and alternatively stacked. Between the emitter zone (10) and the drift region with the compensation structure there is a buffer zone (13) of the first conduction type.

The inventive high power bipolar transistor has increased voltage blocking capability and reduced conduction losses.

## Description

### Field of the Invention

The invention relates to the field of high power semiconductor switches . It relates to a high power bipolar transistor as described in the preamble of claim 1.

### Background of the Invention

Most of the attraction of a MOS-controlled (Metal-Oxide-Silicon) power switch comes from the low power requirements of its gate drive. The most straight forward concept for such a switch is implemented in the power MOSFET (MOS-Field-Effect-Transistor; "Power Semiconductor Devices", B. Jayant Baliga, PWS Publishing Company, 1996, Chapter 7).

Power MOSFETs are however limited in the maximum blocking voltage because of the large resistive voltage drop across the drift region.

A bipolar transistor with an insulated control-gate electrode (IGBT) was introduced in order to cure this problem. The IGBT utilizes a forward biased p-n junction at the anode. The n-type drift region is thus conductivity-modulated in contrast to the power MOSFET.

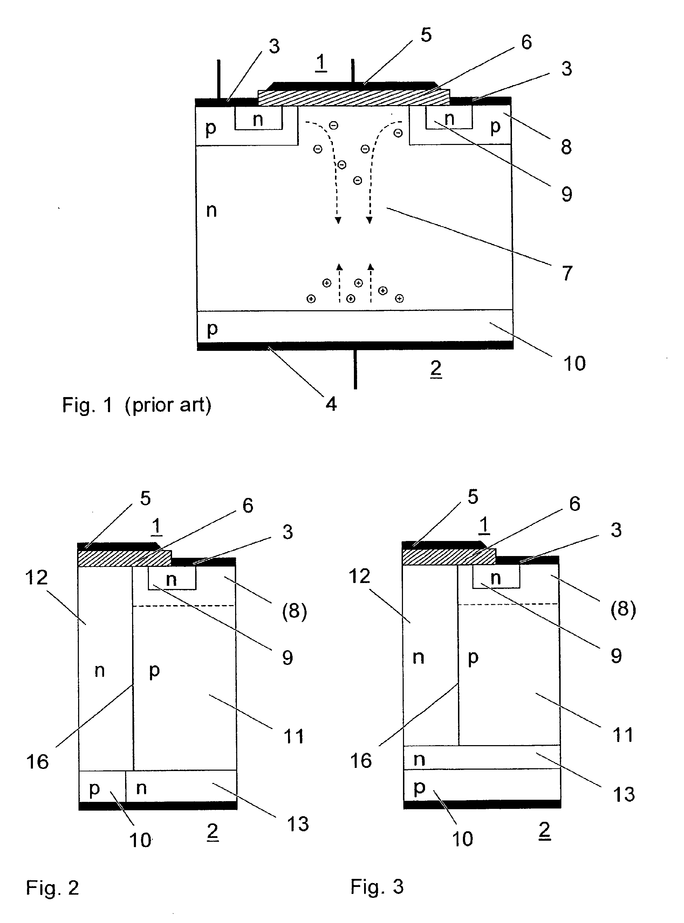

An IGBT according to prior art is shown schematically in Fig. 1. It comprises main electrodes 3 (cathode) and 4 (anode) on opposite first and second surfaces 1 and 2 and an insulated gate electrode 5 on the first surface. A source zone 9 of a first conduction type (n-type) is disposed adjacent the source electrode 3 of the first surface. The source zone is embedded in a base zone 8 of a second conduction type (p-type). Between a p-type emitter zone 10 adjacent the drain electrode 4 and the first surface 1 there is a central, lowly doped (10¹³ cm⁻³) n-type base region 7. In the conductive state the base region is conduction modulated.

The planar IGBT reaches limits when designed for very high blocking voltages: The strong modulation is restricted mainly to the injecting emitter at the anode. The very low plasma concentration towards the cathode is the cause for rather high conduction losses for components in the blocking voltage range above 1 kV.

Current IGBT design activities aim at increasing the plasma level at the cathode by means of hole current encroachment using either trench IGBT structures or advanced planar geometries ("A novel High-Conductivity IGBT (HiGT) with a short circuit capability", M.Mori et al., Proc. of the ISPSD'98, pp. 429).

With the superjunction MOSFET (SJ MOSFET) as described in "COOLMOS™ - a new milestone in high voltage Power MOS", L.Lorenz et al, Proc. Of the ISPSD'99, p. 3-10, another high power electronic switch was recently introduced. It is expected to rival IGBTs up to blocking voltages of 1 kV. This device is briefly described in the next paragraph.

For conventional power MOSFETs, the drain to source on-resistance is proportional to the breakdown voltage up to the power of 2.4 to 2.6. This has so far limited the maximum blocking voltages of power MOSFETs to about 100 V. New high voltage MOSFETs based on the super junction concept are now opening the path towards 600 V. SJ MOSFETs are already commercialized under the product name of CoolMOS.

The SJ MOSFET is based on the MOSFET principle, but the lowly doped n⁻ -drift region is replaced by a succession of alternatingly stacked, more strongly doped p- and n-type semiconductor columns. This means that, in contrast to conventional vertical power devices, the electric field is built up not only in the vertical direction as in standard power MOSFETs, but also in the horizontal direction as well. Therefore, the SJ MOSFET allows the breakdown voltage to be dependent just on the drift region thickness and to be independent of the drift region doping concentration if both p- and n-columns are completely depleted before breakdown takes place. As a result, a given breakdown voltage can be achieved with an SJ MOSFET with a considerably smaller drift region thickness as would be possible using a conventional power MOSFET. This is also the reason for the comparatively lower conduction loss of SJ MOSFETs.

The SJ MOSFET is an unipolar device. In the on-state, current is supported only by electrons in the n-type column. P-type columns do not contribute to current conduction. The density of electrons participating in the current conduction is determined by the n-type doping density in the n-column. To guarantee the depletion of both p- and n-columns during blocking, p- and n-doping concentrations in the columns are chosen to have the same value; this doping concentration has also to be determined in conjuction with the width of the columns. The total space charge in the depleted columns is limited to a value of about 2E12 cm⁻²; above this value, the electric field reaches and exceeds the critical electric field for breakdown in silicon. It turns out that the column doping should be as high as possible for the lowest on-resistance possible but the width of the columns has to be reduced accordingly to assure that the maximum space charge in the columns is not exceeded. The column width is directly related to the cell pitch of the device. And the cell pitch is limited by the technology available; for planar vertically diffused MOS technologies minimum cell pitches are around 6 to 10 µm.

### Description of the Invention

It is an object of the invention to create a high power bipolar transistor of the type mentioned initially, with increased voltage blocking capability and with reduced conduction losses.

These objects are achieved by a high power bipolar transistor according to claim 1.

The central base region of the inventive high power bipolar transistor has a compensation structure for depleting charge carriers when a blocking voltage is applied. The compensation structure comprises columns of the first conduction type and mutually spaced apart columns of the second conduction type. These colums are moderately doped and alternatively stacked. Between the emitter zone and the compensation structure there is a buffer zone of the first conduction type.

The buffer zone completely separates the emitter zone and the colums of the compensation structure which are of the same conduction type. This enables blocking capability of the inventive device.

In a preferred embodiment of the invention the emitter and the buffer zones are disposed as unstructured layers. These layers are easy to produce and with a convenient choice of doping profiles for both buffer and emitter zones extremely high breakdown voltages can be reached. Based on numerical simulations breakdown voltages up to 8 kV seem to be achievable.

In another embodiment of the invention the columns of the first and second conduction type do not extend over the whole length of the device. Instead, a portion of the device close to the anode corresponds to the lowly doped central base of the first conduction type of a conventional IGBT. This so called non-punchthrough structure keeps the electric field from reaching the emitter zone. To further improve this preferred embodiment, a layer of the buffer zone next to the emitter zone has an increased doping concentration. These geometries require thinner compensation structures for the same blocking voltages.

In another embodiment of the invention the compensation structure is partitioned in layers with independent doping concentration levels. This allows for a greater freedom to design the horizontal distribution of the electric field as well as the conductivity of the columns between the two main electrodes.

In another embodiment of the invention the junctions between the columns of the first and second conduction type are graded, thus limiting the maximum variation of dopant density per width. This is easier to produce and of paricular importance to control and limit the peak electric field in order to prevent low breakdown voltages due to second breakdown effects when the inventive device is blocking.

### Brief Description of the Drawings

The subject matter of the invention will be explained in more detail in the following text with reference to preferred exemplary embodiments which are illustrated in the attached drawings, in which:
- Fig. 1: Schematically shows a bipolar transistor with an insulated gate electrode according to prior art;
- Fig. 2: Schematically shows a basic embodiment of the inventive high power bipolar transistor,
- Figs. 3-8: show preferred embodiments of the inventive high power bipolar transistor of Fig. 2,
- Fig. 9: shows a diagram with static on-state current-voltage curves of an inventive high power bipolar transistor compared to a bipolar transistor with an insulated gate electrode according to prior art,
- Fig. 10: shows a diagram with blocking characteristic curves of an inventive high power bipolar transistor compared to a bipolar transistor with an insulated gate electrode according to prior art, and
- Fig. 11: Shows a diagram with trade-off curves of an inventive high power bipolar transistor compared to a bipolar transistor with an insulated gate electrode according to prior art.

The reference symbols used in the drawings, and their meanings, are listed in summary form in the list of reference symbols. In principle, identical parts are provided with the same reference symbols in the figures.

### Detailed Description of Preferred Embodiments

In contrast to Fig. 1, which shows the whole device, in Figs. 2-8 only the right halves of the basically symmetrical devices are shown.

Fig. 2 shows schematically the basic configuration of the inventive high power bipolar transistor, called super junction bipolar transistor (SJBT). Contrary to the SJ MOSFET described above, the p-doped columns 11 of the SJBT participate in the conduction of electricity, so they do not only serve the purpose of blocking as for the SJ MOSFET. A certain portion of the central base region of the SJBT between cathode 3 and anode 4 can be conductivity modulated (as in conventional bipolar power semiconductor devices). A p-type emitter zone 10 replaces the n+drain at the anode side of the SJ MOSFET. It is restricted to the region on the anode side which is conformal with the n-doped column 12. The p-type emitter zone 10 is therefore fully embedded in n-doped silicon.

Would anode and cathode be directly connected via the resistive p-type column 11 the device would have no blocking capability. The electric field would reach the p-type emitter zone 10 and cause strong bipolar injection. The moderately modulated (10¹⁴-10¹⁶ cm⁻³) columns could not be depleted.

In this basic configuration of the SJBT the p-type emitter zone 10 has to be precisely aligned to the position of the n-doped column 12. This is rather unpractical for state-of-the-art technologies considering that the width of a column 12 may be in the range of 1 to 5 µm.

The embodiment of the inventive SJBT shown schematically in Fig. 3 circumvents this problem using unstructured layers for the p+ type emitter zone 10 and a n-type buffer zone 13 on the anode side. This succession of p+ emitter zone and the n-buffer zone is common for high voltage IGBTs of the punchthrough type. With a convenient choice of doping profiles for both n-buffer zone 13 and p+ emitter zone 10, the inventive SJBT can reach extremely high breakdown voltages. Based on numerical device simulation breakdown voltages close to 8 kV seem to be achievable.

Fig. 3 shows the preferred structure of the inventive SJBT upon which further details will be developed.

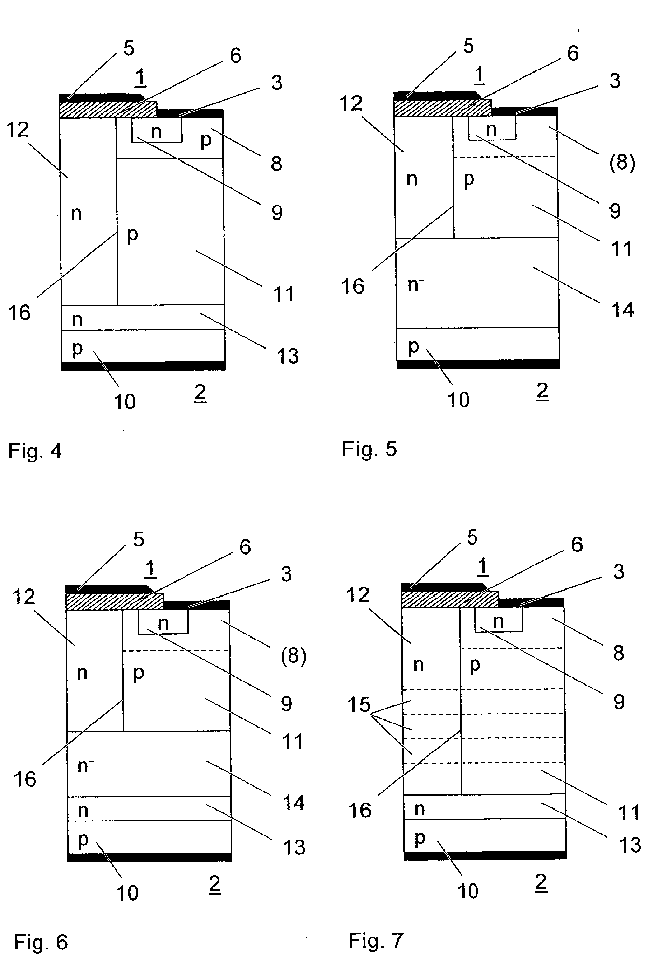

With the hole current flowing in the p-doped column 11, there exists a danger for latch-up for the SJBT in a very similar way as for IGBTs. The SJBT can thus be protected against latch-up using the same wellknown remedies such as an enhancement of the p-doping density of the base zone 8 around the n-type source zone 9 as shown schematically in Fig. 4.

A variation of the basic SJBT from Fig. 3 is shown in fig. 5. The p-type columns 11 and the n-type columns 12 do not extend over the whole length of the device from top to bottom. Instead, a portion of the device close to the anode 4 corresponds to the lowly doped central n-base 14 of a conventional IGBT. This is a non-punchthrough structure and it has to be designed such that the electric field cannot reach the p+type emitter zone at the anode. A corresponding device structure with a field-stop layer (n-type buffer zone) in front of the p+type emitter zone 10 is shown in Fig. 6. Such non-punchthrough geometries require thinner base region thicknesses for the same blocking voltage.

Fig. 7 shows the basic configuration of the inventive SJBT with both the p-type columns 11 and the n-type columns 12 being partitioned in horizontally arranged layers 15 to allow a variation of the doping of both columns from top to bottom. This allows for a greater freedom to design the horizontal distribution of the electric field as well as the condictivity of the columns along the vertical axis from cathode to anode.

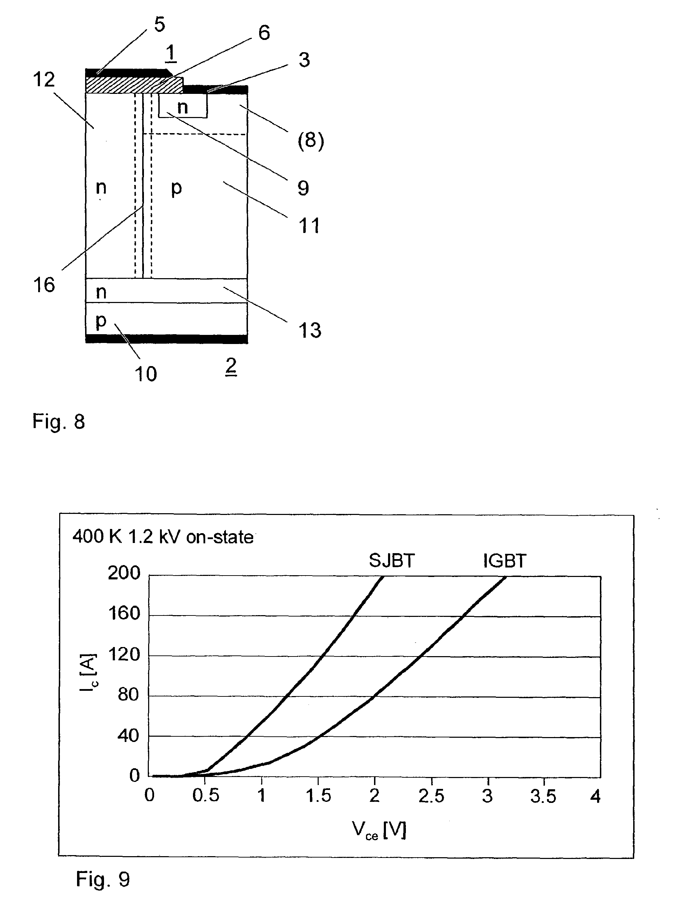

Fig. 8 shows the basic configuration of the inventive SJBT with a restriction on the shape of the vertical p-n junctions between the p-type columns 11 and the n-type columns 12. While it is usually assumed, that these junctions are abrupt, in this embodiment of the inventive SJBT the maximum variation of dopant density per width is restricted such that the junctions become graded. This is of particular importance to control and limit the peak electric field when the device is blocking and thus helps to prevent low breakdown voltages due to second breakdown effects.

In addition, the planar n-channel MOSFET can be replaced by a trench MOSFET. The bottom of the trench fills the width of the p-type column either entirely of paritially. Trench geometries may be used with a large advantage in SJBTs because of the very small cell pitch.

The n-channel MOSFET can further be replaced by a n-channel MESFET structure.

Of course all inventive SJBT described above can be of a complimentary structure. The dopant types of all regions are inverted.

The SJBT can be regarded as a bipolar transistor with high current amplification in contrast to the IGBT with it's wide central n-base zone. Responsible for this is the small n-buffer zone width of the SJBT, which also assumes the duty of a field-stop layer. Both the p-type columns 11 and the n-type columns 12 are resistive connections to the n-type buffer zone 13 and to the p-type base zone near the cathode 3. As in an IGBT, the n-base current is controlled by a MOSFET at the cathode 3 side.

A portion of both the p-type columns 11 and the n-type columns 12 adjacent to the p+type emitter zone 10 on the anode side 4 is conductivity modulated. The amount of conductivity modulation depends on the p+type emitter zone efficiency and also the base transport factor (doping and width of the n-type buffer zone). A large portion of the device close to the cathode 3 is not conductivity-modulated. It can thus be quickly depleted and still provides low resistivity to the current due to the comparatively high doping of both the p-type columns 11 and the n-type columns 12.

The SJBT current saturates at higher collector-emitter voltages than in an IGBT. The saturation current density is rather high and cannot be compared with those of planar IGBTs. It is more in the range of trench IGBT geometries.

Due to the resistive base and collector connections in the SJBT, it's static current-voltage characteristics are considerably more linearized than those of an IGBT. The SJBT can be designed such that it's on-state voltage drop at nominal current is equal (7.5 kV blocking class ) or even lower (1.2 kV blocking class) than a corresponding IGBT. The on-state drop of the SJBT at fractions of the nominal current density is far better than that of an IGBT.

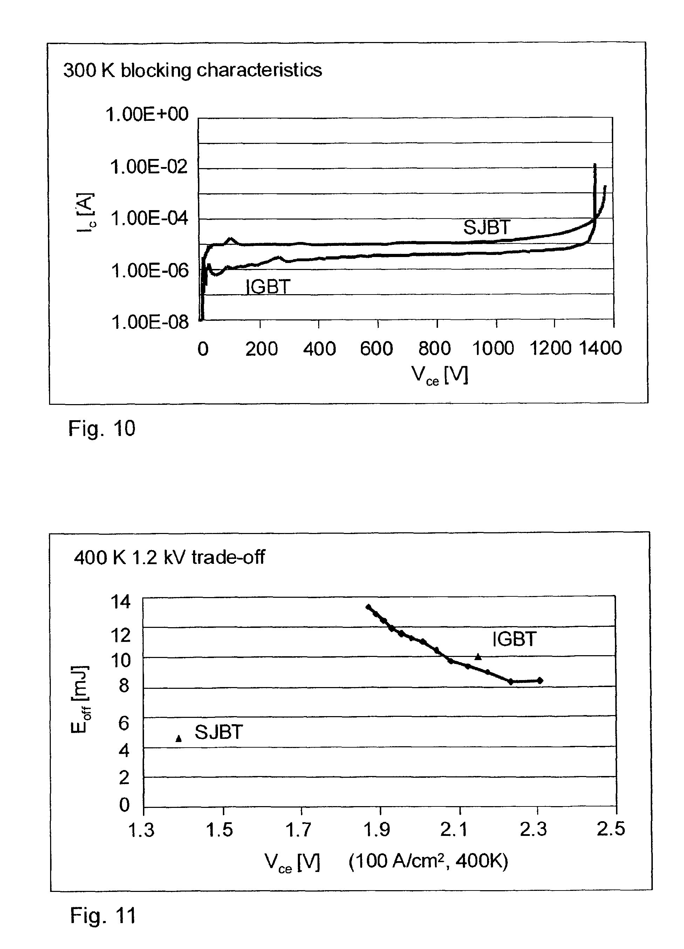

Simulations of both 7.5 kV and 1.2 kV SJBTs indicate that turn-off losses ( hard inductive switching ) are as low as 25% of an equivalent 7.5 kV IGBT ( same on-state voltage drop at nominal current ) or 45% of an equivalent 1.2 kV IGBT ( the SJBT on-state for a 100 A rated chip is at 1.4 V compared to 2.1 to 2.2 V for a planar 1.2 kV SPT IGBT ). A 1.2 kV SJBT can be as thin as 100 µm for a 1380 V breakdown voltage at 300 K. A 7.5 kV SJBT requires a thickness of about 600 µm similar to that of an IGBT. Some basic simulation results for 1.2 kV SJBTs are presented in Figs. 9 to 11.

Once silicon process technology allows to generate vertical columns of alternating doping type in an economical fashion, the inventive high power bipolar transistor will become a power device structure with minimal conduction and switching losses unrivalled by any other non-super junction devices.

### List of designations

- 1: First Surface
- 2: Second Surface
- 3: Main Electrode; Cathode
- 4: Main Electrode; Anode
- 5: Control Electrode; Gate
- 6: Gate Insulation
- 7: Central Base Region
- 8: Base Zone
- 9: Source Zone
- 10: Emitter Zone
- 11: Column of second conduction type, Base
- 12: Column of first conduction type, Base
- 13: Buffer Zone
- 14: Non-punchthrough layer
- 15: Doping variation layers
- 16: Super junction

## Claims

1. A high power bipolar transistor with an insulated control gate comprising:
- a first surface (1) and a second surface (2);
- main electrodes (3, 4) on said first and second surfaces (1, 2);
- an insulated gate electrode (5) on said first surface (1);
- a central base region (7) of a first conduction type between said first and second surfaces (1, 2);
- at least one base zone (8) of a second conduction type being adjacent said central base region (7) and the electrode (3) of said first surface (1);
- at least one source zone (9) of the first conduction type being embedded in said at least one base zone (8);
- at least one emitter zone (10) of the second conduction type being adjacent the electrode (4) of said second surface (2);
**characterized in, that**
- said central base region (7) comprises a compensation structure with columns of the first conduction type (12) and mutually spaced apart columns of the second conduction type (11), said colums being moderately doped and alternatively stacked; and that
- a buffer zone (13) of the first conduction type is disposed between said emitter zone (10) and said columns of the second conduction type (11).

2. Bipolar transistor of Claim 1, **characterized in, that**
- said emitter zone (10) and said buffer zone (13) are disposed as unstructured layers.

3. Bipolar transistor of Claim 1, **characterized in, that**
- said at least one base zone (8) surrounding said source zone (9) has a higher dopant concentration than the columns (11, 12) of said compensation structure.

4. Bipolar transistor of Claim 1 or 2, **characterized in, that**
- said buffer zone (13) comprises a zone (14) with a lower dopant concentration than the columns (11, 12) of said compensation structure.

5. Bipolar transistor of Claim 1 or 2, **characterized in, that**
- said columns (11, 12) of said compensation structure are partitioned in layers (15), each layer having an independent dopant concentration level.

6. Bipolar transistor of Claim 1 or 2, **characterized in, that**
- the junctions (16) between said columns (11, 12) of said compensation structure are graded.
